(19) Europäisches Patentamt
European Patent Office
Office européen des brevets

(11) **EP 2 715 701 B1**

(12) **EUROPÄISCHE PATENTSCHRIFT**

(45) Veröffentlichungstag und Bekanntmachung des Hinweises auf die Patenterteilung:
**22.06.2016 Patentblatt 2016/25**

(51) Int Cl.:
***G06F 17/50*** *(2006.01)*     ***G09B 9/12*** *(2006.01)*

(21) Anmeldenummer: **12723878.0**

(22) Anmeldetag: **31.05.2012**

(86) Internationale Anmeldenummer:
**PCT/EP2012/060266**

(87) Internationale Veröffentlichungsnummer:
**WO 2012/164028 (06.12.2012 Gazette 2012/49)**

(54) **ANSTEUERUNG EINES BEWEGUNGSSYSTEMS**

CONTROL OF A MOTION PLATFORM

CONTRÔLE D'UNE PLATEFORME MOBILE

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **31.05.2011 DE 102011103736**

(43) Veröffentlichungstag der Anmeldung:
**09.04.2014 Patentblatt 2014/15**

(73) Patentinhaber: **Deutsches Zentrum für Luft- und Raumfahrt e.V.
51147 Köln (DE)**

(72) Erfinder: **SEEHOF, Carsten
38110 Braunschweig (DE)**

(74) Vertreter: **Aisch, Sebastian
Gramm, Lins & Partner
Patent- und Rechtsanwälte PartGmbB
Freundallee 13 a
30173 Hannover (DE)**

(56) Entgegenhaltungen:
- ANCA STRATULAT ET AL: "Improving the realism in motion-based driving simulators by adapting tilt-translation technique to human perception", VIRTUAL REALITY CONFERENCE (VR), 2011 IEEE, IEEE, 19. März 2011 (2011-03-19), Seiten 47-50, XP031863510, DOI: 10.1109/VR.2011.5759435 ISBN: 978-1-4577-0039-2
- CASOLO F ET AL: "Functional mechanical design of a low cost driving simulator", MECHATRONICS AND ITS APPLICATIONS, 2008. ISMA 2008. 5TH INTERNATIONAL SYMPOSIUM ON, IEEE, PISCATAWAY, NJ, USA, 27. Mai 2008 (2008-05-27), Seiten 1-6, XP031346500, ISBN: 978-1-4244-2033-9
- ROBUFFO GIORDANO P ET AL: "A novel framework for closed-loop robotic motion simulation - part II: Motion cueing design and experimental validation", 2010 IEEE INTERNATIONAL CONFERENCE ON ROBOTICS AND AUTOMATION : ICRA 2010 ; ANCHORAGE, ALASKA, USA, 3 - 8 MAY 2010, IEEE, PISCATAWAY, NJ, USA, 3. Mai 2010 (2010-05-03), Seiten 3896-3903, XP031743878, ISBN: 978-1-4244-5038-1

**Beschreibung**

Die Erfindung betrifft ein Verfahren zum Ansteuern eines Bewegungssystems eines zum Simulieren von Bewegungs- und/oder Beschleunigungswerten vorgesehenen Simulators, wobei zumindest ein zu simulierender Beschleunigungswert durch eine Neigung des Bewegungssystems gegenüber dem Erdlot simuliert wird, mit Ermitteln eines Neigungswinkelverlaufes des Bewegungssystems, ausgehend von einem Anfangsneigungswinkel des Bewegungssystems zu einem den zu simulierenden Beschleunigungswert entsprechenden Endneigungswinkel, unter Berücksichtigung mindestens einer Neigungsrate.

Die Erfindung betrifft ebenfalls eine Vorrichtung sowie einen Simulator hierzu.

Mit Hilfe von Fahrzeugsimulatoren lassen sich Bewegungen eines Fahrzeuges in der realen Welt simulieren, so dass der Fahrer des Fahrzeuges das Gefühl vermittelt bekommt, als ob er ein Fahrzeug tatsächlich durch die reale Welt steuern würde. So sind beispielsweise Fahrzeugsimulatoren aus dem Stand der Technik bekannt, bei denen im Sichtfeld des Fahrers eine Bildprojektionseinrichtung angeordnet ist, welche dem Fahrer ein Bild der äußeren Umgebung des Fahrzeuges anzeigt. Führt der Fahrer des Fahrzeugsimulators nun Steuerungsaufgaben durch, wie beispielsweise Beschleunigen, Abbremsen oder Lenkeingaben, so wird je nach Steuereingabe das auf der Bildprojektionseinrichtung angezeigte Umgebungsbild an die Steuereingaben entsprechend angepasst und verändert. Derartige Simulatoren sind dabei beispielsweise auch aus den Unterhaltungsmedien und insbesondere aus dem Bereich der Computerspiele bekannt. Neben feststehenden Simulatoren, bei denen lediglich durch das dargestellte Außenbild und deren Veränderung eine Simulation der Veränderung und/oder Beschleunigungen des Fahrzeuges simuliert werden, sind auch Simulatoren bekannt, die zusätzlich hierzu ein Bewegungssystem aufweisen, welches zum Simulieren der auftretenden Bewegungen und Beschleunigungen innerhalb der Simulation in einem definierten Bewegungsraum eingerichtet sind. Dabei lassen sich innerhalb des Bewegungsraumes je nach Simulationstyp bis zu sechs Freiheitsgrade durch das Bewegungssystem abbilden, nämlich zum einen die drei rotatorischen und zum anderen die drei translatorischen Bewegungen in den drei Raumachsen. Insbesondere bei der Simulation von Luftfahrzeugen werden Bewegungssysteme für den Simulator verwendet, die eine Abbildung der Bewegungen des Luftfahrzeuges in alle sechs Freiheitsgrade innerhalb des Bewegungsraumes ermöglichen.

Bis auf wenige Ausnahmen sind die hydraulisch oder elektromechanisch angetriebenen Bewegungssysteme als Parallelroboter aufgebaut, von denen wiederum die Anordnung als Hexapod oder Stuart-Plattform am weitaus häufigsten anzutreffen sind.

Bei derartigen Simulatoren, die über ein aktives Bewegungssystem verfügen, werden die hochfrequenten Anteile der Translationsbeschleunigungen sowie die hochfrequenten Anteil der Rotationsgeschwindigkeiten direkt in die entsprechenden Freiheitsgrade abgebildet, so dass diese Anteile der Translationsbeschleunigungen sowie der Rotationsgeschwindigkeiten direkt aufgrund einer Bewegung des Bewegungssystems spürbar werden. Aufgrund des beschränktes Bewegungsraumes des Bewegungssystems können jedoch niederfrequente Anteile der Translationsbeschleunigungen sowie langanhaltende oder konstante Translationsbeschleunigungen nicht direkt durch eine Bewegung des Bewegungssystems abgebildet werden, sondern werden durch eine Neigung der Bewegungsplattform beziehungsweise des Bewegungssystems dargestellt. Denn durch eine Neigung des Bewegungssystems und somit des gesamten Simulators gegenüber dem Erdlot wird aufgrund der konstanten Erdbeschleunigung der Scheingewichtsvektor innerhalb des Simulators verändert, so dass bei einer gleich bleibenden Lagedarstellung der äußeren Umgebung der Eindruck einer langanhaltenden, translatorischen Beschleunigung entsteht.

Grund hierfür liegt in der Tatsache, dass der menschliche Körper nicht in der Lage ist, eine translatorische Beschleunigung quantitativ richtig zu erfassen, so dass für eine langanhaltende, translatorische Beschleunigung in einem Simulator die überall vorhandene Erdbeschleunigung verwendet werden kann. Hierfür gibt es dann lediglich die Einschränkung, dass eine translatorische Beschleunigung von mehr als einem g quantitativ nicht mehr korrekt dargestellt werden kann.

Neben der Beschränkung auf die Erdbeschleunigung bei der Simulation von langanhaltenden oder konstanten Translationsbeschleunigungen mittels Neigung des Bewegungssystems besteht ein weiteres Problem darin, dass das Bewegungssystem in die Neigungsendlage durch eine rotatorische Bewegung gebracht werden muss. Die Dreh- beziehungsweise Neigungsrate des Bewegungssystems muss dabei derart gewählt werden, dass die Drehung von einer Person in dem Simulator nicht wahrgenommen wird und somit unterhalb der Wahrnehmungsschwelle liegt. Durch diese Einschränkung ergibt sich jedoch in der Regel eine Zeitverzögerung bis zur tatsächlichen Simulation der translatorischen Beschleunigung durch Neigung des Bewegungssystems, die umso größer ausfällt, je größer der Sprung in der zu simulierenden translatorischen Beschleunigung ausfällt. So lässt sich beispielsweise der Start eines Flugzeuges am Anfang quantitativ nicht korrekt durch einen Simulator abbilden, da die translatorische Beschleunigung beim Start ungefähr einer Sprungfunktion entspricht und dann für eine ganze Weile im Wesentlichen konstant anliegt. Da jedoch das Bewegungssystem den Neigungswinkel derart einstellen muss, dass die Dreh- beziehungsweise Neigungsrate unterhalb der Wahrnehmungsschwelle des Menschen liegt, kommt es hier zu einer Zeitverzögerung bis zur Einstellung des gewünschten zu simulierenden Beschleunigungswertes, der oft als störend empfunden wird. Dies führt im Extremfall bis hin zum Auftreten von der sogenannten Simulatorkrankheit.

Aus Stratulat, Anca et al. "Improving the realism in motion-based driving simulators by adapting tilt-translation technique to human perception" ist bekannt, den zu simulierenden Beschleunigungswert sowohl durch Kippen des Simulators als auch durch eine translatorische Bewegung des Simulators zu simulieren, wobei hierfür für verschiedene Beschleunigungs- bzw. Verzögerungswerte ein paar Verhältnisse zwischen translatorischer Bewegung und Neigung angegeben sind.

Aus Casolo F. et al. "Functional mechanical design of a low cost driving simulator" ist ein ähnliches Konzept bekannt, wobei ein sogenannter "washout Algorithmus" in einen hochfrequenten Bereich und in einen niederfrequenten Bereich aufgeteilt wird. Der niederfrequente Bereich soll mit Hilfe einer Neigung des Bewegungssystems simuliert werden, während der hochfrequente Bereich mit Hilfe einer translatorischen Bewegung simuliert werden soll.

## Aufgabe

Vor diesem Hintergrund ist es Aufgabe der vorliegenden Erfindung ein verbessertes Verfahren zum Ansteuern eines Bewegungssystems eines Simulators anzugeben, mit dem die Nachteile der aus dem Stand der Technik bekannten Simulatoren im Hinblick auf die niederfrequenten Anteile beziehungsweise konstanten zu simulierenden Translationsbeschleunigungen zu vermeiden.

## Lösung

Die Aufgabe wird mit dem eingangs genannten Verfahren zum Ansteuern eines Bewegungssystems erfindungsgemäß gelöst durch

- Ermitteln eines translatorischen Bewegungsverlaufes des Bewegungssystems in Abhängigkeit von den zu simulierenden Beschleunigungswert und eine aus dem Neigungswinkelverlauf ermittelten Beschleunigungswertverlauf von simulierten Beschleunigungswerten während der Neigung des Bewegungssystems zur Verminderung eines Simulationsfehlers zwischen den zu simulierenden Beschleunigungswert und den jeweiligen simulierten Beschleunigungswerten des Beschleunigungswertverlaufes, und

- Ansteuern des Bewegungssystems zur Simulation des zu simulierenden Beschleunigungswertes in Abhängigkeit von dem ermittelten Neigungswinkelverlauf und dem ermittelten translatorischen Bewegungsverlauf.

Erfindungsgemäß wird somit vorgeschlagen, dass zusätzlich zu dem Neigungswinkelverlauf, an deren Ende ein Endneigungswinkel des Bewegungssystems eingestellt ist, der dann den zu simulierenden Beschleunigungswert aufgrund der Drehung des Scheingewichtsvektors in dem Simulator entspricht, zusätzlich ein translatorischer Bewegungsverlauf des Bewegungssystems in Abhängigkeit von dem zu simulierenden Beschleunigungswert und einem aus dem Neigungswinkelverlauf ermittelten Beschleunigungswertverlauf von simulierten Beschleunigungswerten während der Neigung des Bewegungssystems ermittelt wird. Die Ansteuerung des Bewegungssystems zur Simulation des zu simulierenden Beschleunigungswertes erfolgt dann sowohl in Abhängigkeit von den ermittelten Neigungswinkelverlauf als auch von dem ermittelten translatorischen Bewegungsverlauf.

Durch die Ausnutzung des zur Verfügung stehenden translatorischen Bewegungsraumes zusätzlich zu der Neigung des Bewegungssystems zur Simulation der translatorischen Beschleunigung kann der Simulationsfehler, der aufgrund der Zeitverzögerung bis zur Einstellung des Endneigungswinkels besteht, verringert werden. Dieser Simulationsfehler entsteht dabei aufgrund der Tatsache, dass der Endneigungswinkel zur Simulation des zu simulierenden Beschleunigungswertes nur zeitverzögert eingestellt werden kann, da die Drehrate beziehungsweise Neigungsrate unterhalb der Wahrnehmungsschwelle des Menschen beziehungsweise der in dem Simulator befindlichen Person gewählt werden muss. Steigt der zu simulierende Beschleunigungswert sprunghaft an, wie beispielsweise beim Start eines Flugzeuges, so entspricht der in der Simulatorkabine aufgrund der Neigung eingestellte Beschleunigungswert nicht dem zu simulierenden Beschleunigungswert, solange der Endneigungswinkel nicht eingestellt ist.

Durch die zusätzliche Verwendung des translatorischen Bewegungsraumes während der Neigung des Bewegungssystems zur Einstellung des Endneigungswinkels lässt sich dieser Simulationsfehler verringern oder unter bestimmten Umständen sogar ganz vermeiden, da durch die zusätzliche translatorische Bewegung des Bewegungssystems aufgrund des translatorischen Bewegungsverlaufes zusätzliche Beschleunigungswerte nachgebildet werden, die zusammen mit dem Neigungsverlauf und dem daraus ableitbaren Beschleunigungswertverlauf der zu simulierenden Translationsbeschleunigung entspricht.

Durch die Ansteuerung des Bewegungssystems nunmehr in Abhängigkeit von dem Neigungswinkelverlauf sowie dem ermittelten translatorischen Bewegungsverlauf wird erreicht, dass der eine zu simulierende Beschleunigungswert sowohl durch eine rotatorische Bewegung zur Erreichung des Endneigungswinkels als auch durch eine translatorische Bewegung des Bewegungssystems in Kombination simuliert wird.

Vorteilhafterweise könnte der Beschleunigungswertverlauf zum Beispiel durch die Funktion

$$a(t) = g \cdot \sin(\Theta(t))$$

ermittelt beziehungsweise abgeleitet, wobei a(t) der Beschleunigungswertverlauf, g die Erdbeschleunigung und $\Theta$(t) der Neigungswinkelverlauf ist.

Des Weiteren ist es ganz besonders vorteilhaft, wenn der translatorische Bewegungsverlauf des Bewegungssystems weiter in Abhängigkeit von einem noch zur Verfügung stehenden Raumes des Bewegungssystems, ausgehend von einer Ausgangsposition des Bewegungssystems, ermittelt wird. Durch die Beachtung des noch zur Verfügung stehenden translatorischen Bewegungsraumes kann beispielsweise sichergestellt werden, dass die translatorische Bewegung des Bewegungssystems zum Ausgleich des Simulationsfehlers nicht abrupt am Ende des Bewegungsraumes des Bewegungssystems endet. Denn der Bewegungsraum des Bewegungssystems ist grundsätzlich beschränkt, so dass nur Bewegungen innerhalb des Bewegungsraumes durchführbar sind.

Durch die Beachtung des noch zur Verfügung stehenden translatorischen Bewegungsraumes, ausgehend von einer Ausgangs- beziehungsweise IstPosition des Bewegungssystems, kann der Bewegungsraum hinsichtlich der Minimierung des Fehlers optimal ausgenutzt werden, um die parasitären Beschleunigungswerten so weit wie möglich zu vermieden.

Des Weiteren ist es ganz besonders vorteilhaft, wenn der translatorische Bewegungsverlauf zur Minimierung des Simulationsfehlers weiter in Abhängigkeit einer Ausgangsbewegung des Bewegungssystems ermittelt wird. Dadurch lässt sich zum Beispiel bei einem sprunghaften Anstieg eines zu simulierenden Beschleunigungswertes dieses Verfahren nahtlos in eine bereits eingesteuerte Bewegung des Bewegungssystems integrieren, ohne dass es hier zu einer abrupten Änderung der Bewegungen atypisch zu der eigentlichen Simulation kommt.

Des Weiteren ist es ganz besonders vorteilhaft, wenn der translatorische Bewegungsverlauf unter Berücksichtigung der Randbedingung ermittelt wird, dass zum Zeitpunkt des Erreichens des Endneigungswinkels keine translatorische Bewegung des Bewegungssystems mehr ausgeführt wird. Durch diese Randbedingung, die der translatorische Bewegungsverlauf gerecht werden muss, lässt sich beispielsweise verhindern, dass es zum Zeitpunkt des Erreichens des Endneigungswinkels zu einem Sprung in der simulierten Beschleunigung kommt.

Des Weiteren ist es ganz besonders vorteilhaft, wenn der Neigungswinkelverlauf in Abhängigkeit von einer Neigungsrate ermittelt wird, die konstant oder zeitabhängig angenommen werden kann und nicht mehr als 3° pro Sekunde beträgt. Für diesen Wert kann nach Stand der Forschung davon ausgegangen werden, dass die Neigungsrate unterhalb der Wahrnehmungsschwelle liegt, so dass eine Neigung mit einer derartigen Neigungsrate nicht als Drehung wahrgenommen wird, sondern im fahrzeugfesten Koordinatensystem als Drehung des Scheingewichtsvektors, was als Beschleunigung empfunden wird.

Die Ermittlung des translatorischen Bewegungsverlaufes kann dabei vorteilhafterweise in Abhängigkeit einer Ausgleichsfunktion erfolgen, die zumindest den zu simulierenden Beschleunigungswert und den aus dem Neigungswinkelverlauf ermittelten Beschleunigungswertverlauf während der Neigung des Bewegungssystems berücksichtigt. Des Weiteren kann je nach Komplexität der Ausgleichsfunktion auch der Ist-Zustand des Bewegungssystems in den jeweiligen Freiheitsgraden sowie der sich daraus ableitende noch zur Verfügung stehende Bewegungsraum mitberücksichtigt werden, um den translatorischen Bewegungsverlauf mittels der Ausgleichsfunktion ermitteln zu können.

Bei der Ermittlung des translatorischen Bewegungsverlaufes hat sich herausgestellt, dass zum Beispiel die folgende Weg-Funktion (Ausgleichsfunktion) 5. Grades vorteilhaft für die Ermittlung des translatorischen Bewegungsverlaufes ist:

$$s(t) = a*t^5 + b*t^4 + c*t^3 + d*t^2 + e*t + f.$$

Wobei die Koeffizienten wie folgt sind:

$$a = -\frac{\alpha_{anf}}{2t_1^3} - 3\frac{V_{ist}}{t_1^4} - 6\frac{\chi_{ist} - \chi_{end}}{t^{1^5}}$$

$$b = \frac{3}{2}\frac{\alpha_{anf}}{t_1^2} + 8\,\frac{V_{ist}}{t_1^3} + 15\,\frac{\chi_{ist} - \chi_{end}}{t_1^4}$$

$$c = \frac{3}{2}\frac{\alpha_{anf}}{t_1} - 6\,\frac{V_{ist}}{t_1^2} - 10\,\frac{\chi_{ist} - \chi_{end}}{t_1^3}$$

$$d = \frac{\alpha_{anf}}{2}$$

$$e = v_{ist}$$

$$f = \chi_{ist}$$

Dabei stellt $a_{nf}$ die Anfangsbeschleunigung, $v_{ist}$ die aktuelle Beschleunigung des Bewegungssystems, $\chi_{ist}$ der aktuelle Weg des Bewegungssystems in der betrachteten Richtung, $\chi_{end}$ der maximal mögliche Weg des Bewegungssystems, ausgehend von $\chi_{ist}$, und t die Zeit bis zum Erreichen des Endneigungswinkels dar.

Da das vorliegende erfindungsgemäße Verfahren grundsätzlich echtzeitfähig ist, kann die Berechnung während der Simulation von Bewegungs- und/oder Beschleunigungswerten bei jedem Zeitschritt neu durchgeführt werden. Denn es kann passieren, dass während der Zeitspanne bis zum Anfahren des Endneigungswinkels neue zu simulierende Eingangsbeschleunigungswerte anliegen, die nunmehr simuliert werden sollen. Unter Berücksichtigung des Ist-Zustandes des Bewegungssystems und dem somit noch zur Verfügung stehenden Bewegungsraum lässt sich somit auf Grundlage des vorliegenden Verfahrens eine neuerliche Ansteuerung ermitteln und durchführen, so dass auf die sich ändernden Gegebenheiten schnell und in Echtzeit reagiert werden kann.

Im übrigen ist es auch Aufgabe der vorliegenden Erfindung eine verbesserte Vorrichtung zum Ansteuern eines Bewegungssystems zum Simulieren von Bewegungs- und/oder Beschleunigungswerten anzugeben, welche die aus dem Stand der Technik bekannten Nachteile bei derartigen Simulatoren im Hinblick auf translatorische Beschleunigungswerte vermeidet.

Diese Aufgabe wird mit einer Vorrichtung zum Ansteuern eines Bewegungssystems eines zum Simulieren von Bewegungs- und/oder Beschleunigungswerten vorgesehenen Simulators gelöst mit mindestens einer Eingabeschnittstelle zum Vorgehen von zumindest einem zu simulierenden Beschleunigungswert und mit mindestens einer mit dem Bewegungssystems verbindbaren Ausgabeschnittstelle zum Ansteuern des Bewegungssystems, wobei die Vorrichtung eine mit der mindestens einen Eingabeschnittstelle und Ausgabeschnittstelle verbundenen Recheneinheit hat, die zur Durchführung des vorstehenden Verfahrens zum Ansteuern des Bewegungssystems eingerichtet ist.

Die Aufgabe wird im Übrigen auch mit einem Simulator gelöst mit einem Bewegungssystem zum Simulieren von Bewegungs- und/oder Beschleunigungswerten und einer mit dem Bewegungssystem verbundenen und zum Ansteuern des Bewegungssystems vorgesehenen und vorstehend genannten Vorrichtung.

Die Erfindung wird anhand der beigefügten Zeichnungen beispielhaft näher erläutert. Es zeigen:

Figur 1 - Darstellung des Fehlers zwischen gefühlter und zu simulierender Beschleunigung;

Figur 2 - optimierter Beschleunigungsverlauf mit Ausgleichsfunktion;

Figur 3 - Darstellung des Weg-Verlaufes bei der translatorischen Zusatzbeschleunigung;

Figur 4 - Bewegungsverlauf in einem 2D-Bewegungsraum.

Das erfindungsgemäße Verfahren der vorliegenden Erfindung beruht auf dem aus dem Stand der Technik bekannten Verfahren, dass die niederfrequenten beziehungsweise konstanten translatorischen Beschleunigungswerte durch eine Neigung des Bewegungssystems spürbar werden. Denn sowohl eine konstant andauernde translatorische Beschleunigung der Simulatorkabine als auch eine Neigung der Simulatorkabine äußern sich für eine Person in dem Simulator in einer Veränderung des Scheinlots beziehungsweise des Scheingewichtsvektors gegenüber dem fahrzeugfesten Koordinatensystem. Bei einer translatorischen Beschleunigung des Bewegungssystems weicht dabei dieses in der Simulatorkabine fühlbare Scheinlot von dem tatsächlichen Erdlot ab, während bei einer Neigung der Simulatorkabine das Scheinlot dem Erdlot entspricht. Da der menschliche Organismus nicht in der Lage ist, den Unterschied zwischen diesen beiden Beschleunigungsarten zu unterscheiden, kann das Erdlot und die daraus resultierende Erdbeschleunigung zur Simulation von Beschleunigungswerten verwendet werden.

Allerdings stellt die Neigungsrate, mit der das Bewegungssystem einen Neigungswinkel zur Simulation einer translatorischen Beschleunigung einstellen soll, eine Beschränkung dar. Denn die Neigungsrate muss so gewählt werden, dass die durchgeführte Neigung nicht als solche wahrnehmbar ist. In der Regel hat sich herausgestellt, dass eine Neigungsrate von beispielsweise nicht mehr als 3° pro Sekunde unterhalb der Wahrnehmungsschwelle eines Menschen liegt und somit nicht als rotatorische Bewegung wahrgenommen wird, sondern als eine linear steigende translatorische Beschleunigung.

Für die Darstellung einer lang anhaltenden translatorischen Beschleunigung steht somit lediglich die Erdbeschleunigung $g = 9{,}81\ m/s^2$ zur Verfügung. Hieraus ergibt sich eine Gesamtbeschleunigung, die sich wie folgt errechnet:

$$\left|\overline{a_{ges}}\right| = \sqrt{a_x^2 + a_y^2 + a_z^2}$$

Bei einer angenommenen Beschleunigung in X Richtung von beispielsweise $4\ m/s^2$ errechnet sich nach der oben genannten Formel somit die Gesamtbeschleunigung zu:

$$\left|\overline{a_{ges}}\right| = \sqrt{\left(4\ \frac{m}{s^2}\right)^2 + \left(9{,}81\ \frac{m}{s^2}\right)^2} \approx 10{,}5\ \frac{m}{s^2}$$

Wie zu erkennen ist, ist die Gesamtbeschleunigung größer als die maximal darstellbare Erdbeschleunigung von $9{,}81\ m/s^2$. Hieraus folgt für diesen Fall eine Verringerung der tatsächlich messbaren konstanten Beschleunigung in X, so dass sich der korrigierte Beschleunigungsvektor sich ergibt zu:

$$\overline{a_{const}} = \frac{a_{ges}}{\left|\overline{a_{ges}}\right|} \approx \begin{pmatrix} 3{,}70 \\ 0 \\ 9{,}09 \end{pmatrix} m/s^2$$

Anhand des oben gemachten Beispieles mit einer zu simulierenden Beschleunigung von $4\ m/s^2$ ergibt sich somit ein Winkel zwischen dem Scheinlot als Richtung der Gesamtbeschleunigung und der zum Erdmittelpunkt weisenden z-Achse der Simulatorkabine wie folgt:

$$\Theta_s = \arcsin\left(\frac{a_{x,ges}}{\left|\overline{a_{ges}}\right|}\right) = \arcsin\left(\frac{4\ \frac{m}{s^2}}{\sqrt{\left(4\ \frac{m}{s^2}\right) + \left(9{,}81\ \frac{m}{s^2}\right)}}\right) \approx 21{,}6°$$

Durch die Drehung des Bewegungssystems wird somit eine Neigung aufgebaut, die eine Person in der Simulatorkabine als Drehung des Scheinlotes beziehungsweise als Drehung des Scheingewichtsvektors gegenüber der z-Achse wahrnimmt, während das Scheinlot tatsächlich mit dem Erdlot übereinstimmt. Die durch die Neigung spürbare translatorische Beschleunigung ergibt sich dabei wie folgt:

$$a_{x,ges} = g \cdot \sin(\Theta_s).$$

Folgt nun ein Sprung in der Eingangsbeschleunigung, das heißt in der zu simulierenden translatorischen Beschleunigung, so hängt die simulierte Beschleunigung aufgrund der Beschränkung der Neigungsrate der zu simulierenden translatorischen Beschleunigung so lange hinterher, bis der entsprechende Endneigungswinkel eingestellt ist, wenn man einmal den konstanten und den System immanenten Fehler vernachlässigt.

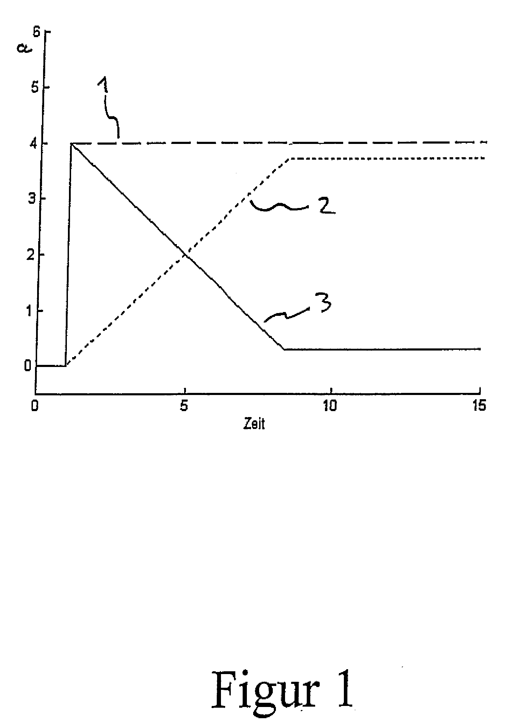

Diesen so entstehenden Simulationsfehler beziehungsweise Scheinlotfehler ist in Figur 1 dargestellt. Zu simulieren ist eine sprunghaft angestiegene translatorische Beschleunigung 1, wie sie beispielsweise bei einem Flugzeugstart zu finden ist. Aufgrund der Beschränkung der Neigungsrate steigt die durch den Neigungswinkel aufgebaute translatorische Beschleunigung 2 nur langsam an. Der dabei entstehende Fehler ist mit dem Verlauf 3 aufgezeichnet.

Wie zu erkennen ist, ist der Fehler 3 zum Zeitpunkt des Beginns der translatorischen Beschleunigung 1 (Zeitpunkt $t_0$) am größten. Mit zunehmenden Aufbau des Neigungswinkels des Bewegungssystems steigt die durch die Neigung aufgebaute translatorische Beschleunigung 2 weiter an, so dass der Fehler 3 im gleichen Maße absinkt. Der Fehler ergibt sich dabei zu

$$\ddot{x} = \Delta a_x = a_{x,const} - g \cdot \sin(\Theta(t))$$

Wobei $\Theta(t)$ der Neigungswinkelverlauf ist und $a_{x,const}$ die zu simulierende translatorische Beschleunigung 1.

Erfindungsgemäß wird nun der zur Verfügung stehende Bewegungsraum in translatorischer Richtung genutzt, um diesen so entstehenden Fehler beziehungsweise Simulationsfehler 3 auszugleichen beziehungsweise zu verringern, umso eine wesentlich bessere Abbildung der zu simulierenden translatorischen Beschleunigung 1 durch eine Simulatorkabine zu erreichen.

Für den translatorischen Bewegungsverlauf, der diesen Simulationsfehler 3 verringern soll, wird eine Ausgleichsfunktion gewählt. Dies könnte beispielsweise wie folgt aussehen:

$$s(t) = a \cdot t^5 + b \cdot t^4 + c \cdot t^3 + d \cdot t^2 + e \cdot t + f$$

mit den Koeffizienten

$$a = -\frac{a_{anf}}{2t_1^3} - 3\frac{v_{ist}}{t_1^4} - 6\frac{x_{ist} - x_{end}}{t_1^5}$$

$$b = \frac{3}{2}\frac{a_{anf}}{t_1^2} + 8\frac{v_{ist}}{t_1^3} + 15\frac{x_{ist} - x_{end}}{t_1^4}$$

$$c = -\frac{3}{2}\frac{a_{anf}}{t_1} - 6\frac{v_{ist}}{t_1^2} - 10\frac{x_{ist} - x_{end}}{t_1^3}$$

$$d = \frac{a_{anf}}{2}$$

$$e = v_{ist}$$

$$f = x_{ist}$$

wobei $v_{ist}$ und $x_{ist}$ den aktuellen Zustand des Bewegungssystems in x-Richtung beschreiben und $x_{end}$ der beigegebene Bewegungsraum maximal möglicher Weg ist, bis der Lage- bzw. Neigungswinkel eingenommen wurde. Die Zeit $t_1$ ergibt sich aus dem anzufahrenden Neigungswinkel geteilt durch die maximal zulässige Drehrate, welche nicht als solche erkannt wird. Für dieses Beispiel wird von einem Wert von 3° pro Sekunde ausgegangen.

Weitere Randbedingungen, die hier berücksichtigt wurden, sind:

$$\ddot{x}(t_1) = 0$$

$$\ddot{x}(t_0) = \ddot{x}_{anf} = a_{anf}$$

$$\dot{x}(t_0) = \dot{x}_{ist} = v_{ist}$$

$$x(t_0) = x_{ist}$$

$$\dot{x}(t_1) = 0$$

$$x(t_1) = x_{end}$$

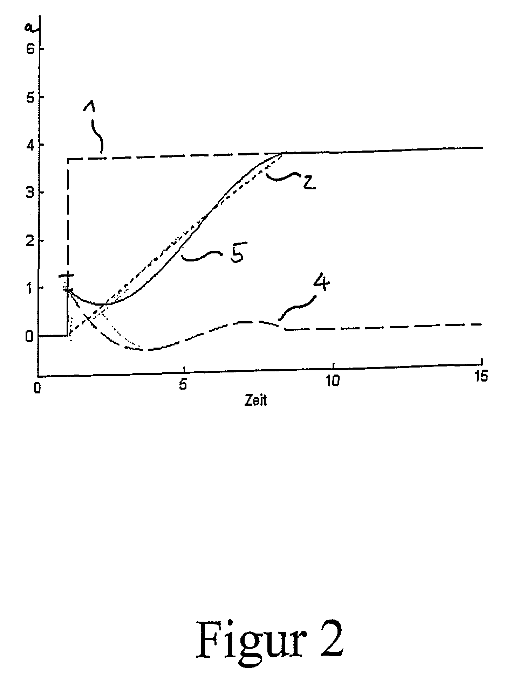

Unter Berücksichtigung des translatorischen Bewegungsraumes und der bei gegebenen Ist-Zustand des Bewegungssystems noch mögliche translatorische Weg lässt sich somit der Simulationsfehler 3 durch eine entsprechende translatorische Bewegung ausgleichen bzw. zumindest verringern, so dass sich ein optimierter Beschleunigungsverlauf ergibt, wie er in Figur 2 dargestellt ist. Zusammen mit dem Anteil der Ausgleichsfunktion 4, wie oben beispielhaft gezeigt, ergibt sich somit eine gefühlte Ist-Beschleunigung 5, so wie sie beim Zusammenspiel des Neigungsverlaufes und der zusätzlichen translatorischen Bewegung von einer Person im Simulator wahrgenommen wird. Zu erkennen ist dabei insbesondere, dass gerade am Anfang die Ist-Beschleunigung ebenfalls mit sprunghaft ansteigt, wobei dann aufgrund der Beschränkung des Bewegungsraumes des Bewegungssystems diese translatorische Bewegung leicht zurückgefahren wird, um dann am Ende noch mal einen Ausgleich zu schaffen.

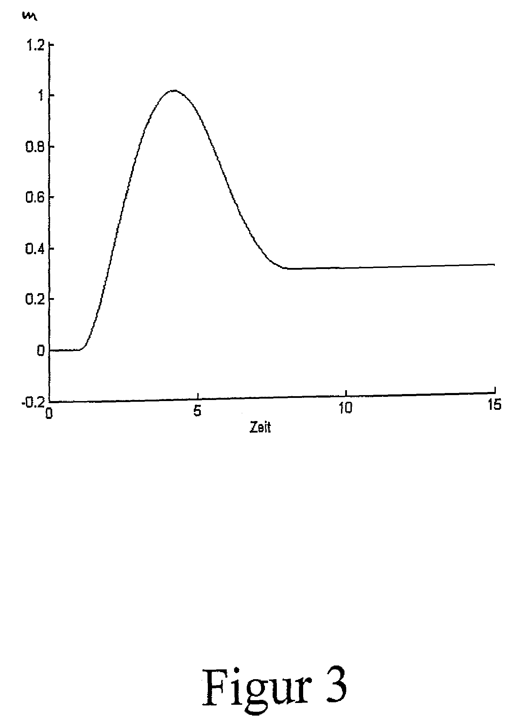

Der dabei zurückgelegte Weg gemäß der Ausgleichsfunktion 4 ist dabei in Figur 3 dargestellt.

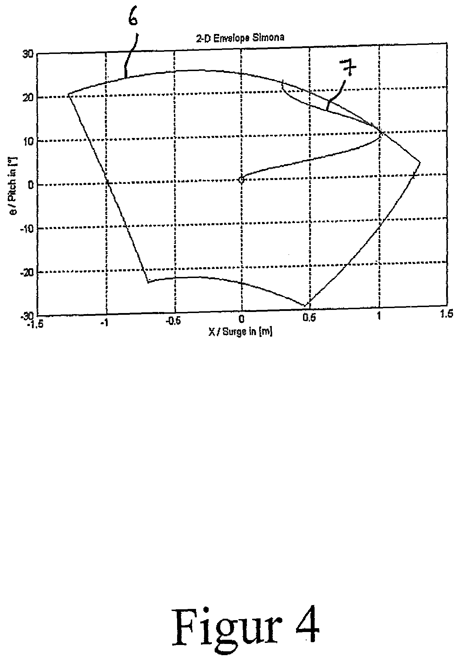

Die durch diesen Beschleunigungsverlauf verursachte Auslenkung des Systems wird in Figur 4 anhand eines zweidimensionalen Bewegungsraumes 6 dargestellt. Der Bewegungsraum 6, auch Envelope genannt, beschreibt dabei die möglichen translatorischen Bewegungsfreiheiten, die bei gegebenem Ist-Zustand des Systems noch möglich sind. Im Beispiel der Figur 4 ist dabei auf der y-Achse der Neigungswinkel aufgetragen, während auf der x-Achse die Bewegung des Bewegungssystems in x-Richtung aufgetragen ist.

Der dargestellte Bewegungsverlauf 7 zeigt dabei in dieser Darstellung, wie sich das Bewegungssystem zur Simulation des simulierenden translatorischen Beschleunigungswertes verhält und bewegt. Insbesondere ist zu erkennen, dass eine große Auslenkung in x-Richtung durchgeführt wird, um den Simulationsfehler bei der Neigung des Bewegungssystems auszugleichen. Dabei wird das Bewegungssystem bis an den Rand des möglichen Bewegungsraumes gefahren, um so den translatorischen Bewegungsraum voll ausnutzen zu können. In der im genannten Beispiel vorgestellten Funktion erfolgt ein leichtes Zurückfahren, um am Ende, d.h. kurz vor Erreichen des Endneigungswinkels, noch einmal eine translatorische Beschleunigung einzufahren, um einen Sprung beim Erreichen des Endneigungswinkels zu vermeiden.

**Patentansprüche**

1.  Verfahren zum Ansteuern eines Bewegungssystems eines zum Simulieren von Bewegungs- und/oder Beschleunigungswerten vorgesehenen Simulators, wobei die drei rotatorischen und die drei translatorischen Bewegungen in den drei Raumachsen durch das Bewegungssystem abgebildet werden, und wobei zumindest ein zu simulierender Beschleunigungswert (1) durch eine Neigung des Bewegungssystems gegenüber dem Erdlot simuliert wird, mit

- Ermitteln eines Neigungswinkelverlaufes des Bewegungssystems, ausgehend von einem Anfangsneigungswinkel des Bewegungssystems zu einem den zu simulierenden Beschleunigungswert (1) entsprechenden Endneigungswinkel, unter Berücksichtigung mindestens einer Neigungsrate,

**gekennzeichnet durch**

- Ermitteln eines translatorischen Bewegungsverlaufes (5) des Bewegungssystems in Abhängigkeit von dem zu simulierenden Beschleunigungswert (1) und einem aus dem Neigungswinkelverlauf ermittelten Beschleunigungswertverlauf (2) von simulierten Beschleunigungswerten während der Neigung des Bewegungssystems zur Verminderung eines Simulationsfehlers (3) zwischen dem zu simulierenden Beschleunigungswert (1) und den jeweiligen simulierten Beschleunigungswerten des Beschleunigungswertverlaufes (2), und
- Ansteuern des Bewegungssystems zur Simulation des zu simulierenden Beschleunigungswertes in Abhängigkeit von dem ermittelten Neigungswinkelverlauf und dem ermittelten translatorischen Bewegungsverlauf (5).

2. Verfahren nach Anspruch 1, **gekennzeichnet durch** Ermitteln des Beschleunigungswertverlaufes (2) **durch** die Funktion

$$a(t) = g * \sin( \Theta(t) )$$

wobei a(t) der Beschleunigungswertverlauf, g die Erdbeschleunigung und $\Theta(t)$ der Neigungswinkelverlauf ist.

3. Verfahren nach Anspruch 1 oder 2, **gekennzeichnet durch** Ermitteln des translatorischen Bewegungsverlaufes (5) des Bewegungssystems weiterhin in Abhängigkeit von einem zur Verfügung stehenden Bewegungsraumes (6) des Bewegungssystems, ausgehend von einer Ausgangsposition ($s_{ist}$) des Bewegungssystems.

4. Verfahren nach einem der vorhergehenden Ansprüche, **gekennzeichnet durch** Ermitteln des translatorischen Bewegungsverlaufes (5) des Bewegungssystems weiterhin in Abhängigkeit von einer Ausgangsbewegung ($v_{ist}$) des Bewegungssystems.

5. Verfahren nach einem der vorhergehenden Ansprüche, **gekennzeichnet durch** Ermitteln des translatorischen Bewegungsverlaufes (5) unter Berücksichtigung der Randbedingung, dass zum Zeitpunkt des Erreichens des Endneigungswinkels keine translatorische Bewegung des Bewegungssystems mehr ausgeführt wird.

6. Verfahren nach einem der vorhergehenden Ansprüche, **gekennzeichnet durch** Ermitteln des Neigungswinkelverlaufes in Abhängigkeit von einer konstanten oder zeitabhängigen Neigungsrate zum Beispiel von 3° pro Sekunde.

7. Verfahren nach einem der vorhergehenden Ansprüche, **gekennzeichnet durch** Ermitteln des translatorischen Bewegungsverlaufes (5) in Abhängigkeit von der folgenden Weg-Funktion (4):

$$s(t) = a \cdot t^5 + b \cdot t^4 + c \cdot t^3 + d \cdot t^2 + e \cdot t + f$$

mit

$$a = -\frac{a_{anf}}{2t_1^3} - 3\frac{v_{ist}}{t_1^4} - 6\frac{x_{ist} - x_{end}}{t_1^5}$$

$$b = \frac{3}{2}\frac{a_{anf}}{t_1^2} + 8\frac{v_{ist}}{t_1^3} + 15\frac{x_{ist} - x_{end}}{t_1^4}$$

$$c = -\frac{3}{2}\frac{a_{anf}}{t_1} - 6\frac{v_{ist}}{t_1^2} - 10\frac{x_{ist} - x_{end}}{t_1^3}$$

$$d = \frac{a_{anf}}{2}$$

$$e = v_{ist}$$

$$f = x_{ist}$$

wobei $a_{anf}$ die Anfangsbeschleunigung, $v_{ist}$ die aktuelle Beschleunigung des Bewegungssystems, $s_{ist}$ der aktuelle Weg des Bewegungssystems in der betrachteten Richtung, $s_{end}$ der maximal mögliche Weg des Bewegungssystems, ausgehend von $s_{ist}$, und t die Zeit bis zum Erreichen des Endneigungswinkels ist.

8. Vorrichtung zum Ansteuern eines Bewegungssystems eines zum Simulieren von Bewegungs- und/oder Beschleunigungswerten vorgesehenen Simulators, wobei die drei rotatorischen und die drei translatorischen Bewegungen in den drei Raumachsen durch das Bewegungssystem abgebildet werden, und mit mindestens einer Eingabeschnittstelle zum Vorgeben von zumindest einem zu simulierenden Beschleunigungswert und mit mindestens einer mit dem Bewegungssystem verbindbaren Ausgabeschnittstelle zum Ansteuern des Bewegungssystems, wobei die Vorrichtung eine mit der mindestens einen Eingabeschnittstelle und Ausgabeschnittstelle verbundene Recheneinheit hat, die zur Durchführung des vorstehenden Verfahrens nach einem der Ansprüche 1-7 zum Ansteuern des Bewegungssystems eingerichtet ist.

9. Simulator mit einem Bewegungssystem zum Simulieren von Bewegungs- und/oder Beschleunigungswerten und einer mit dem Bewegungssystem verbundenen und zum Ansteuern des Bewegungssystems vorgesehenen Vorrichtung nach Anspruch 8.

## Claims

1. A method for controlling a motion system of a simulator provided for simulating motion values and/or acceleration values, wherein the three rotational and the tree translational motions in the three spatial axes are mapped by the motion system, and wherein at least one acceleration value (1) to be simulated is simulated by an inclination of the motion system relative to the perpendicular to the earth, comprising

   - determining an inclination angle profile of the motion system, proceeding from a starting inclination angle of the motion system to an end inclination angle corresponding to the acceleration value (1) to be simulated, taking account of at least one inclination rate,

   **characterized by**

   - determining a translational motion profile (5) of the motion system depending on the acceleration value (1) to be simulated and depending on an acceleration value profile (2) determined from the inclination angle profile of simulated acceleration values during the inclination of the motion system in order to reduce a simulation error (3) between the acceleration value (1) to be simulated and the respective simulated acceleration values of the acceleration value profile (2), and
- controlling the motion system for the simulation of the acceleration value to be simulated depending on the inclination angle profile determined and the translational motion profile (5) determined.

2. The method as claimed in claim 1, **characterized by** determining the acceleration value profile (2) by means of the function

$$a(t) = g * \sin(\theta(t))$$

where a(t) is the acceleration value profile, g is the acceleration due to gravity, and $\theta$(t) is the inclination angle profile.

3. The method as claimed in claim 1 or 2, **characterized by** determining the translational motion profile (5) of the motion system furthermore depending on an available motion space (6) of the motion system, proceeding from an initial position ($s_{actual}$) of the motion system.

4. The method as claimed in any of the preceding claims, **characterized by** determining the translational motion profile (5) of the motion system furthermore depending on an initial motion ($v_{actual}$) of the motion system.

5. The method as claimed in any of the preceding claims, **characterized by** determining the translational motion profile (5) taking account of the boundary condition that a translational motion of the motion system is no longer performed at the point in time when the end inclination angle is attained.

6. The method as claimed in any of the preceding claims, **characterized by** determining the inclination angle profile depending on a constant or time-dependant inclination rate for example of 3° per second.

7. The method as claimed in any of the preceding claims, **characterized by** determining the translational motion profile (5) depending on the following distance function (4):

$$s(t) = a \cdot t^5 + b \cdot t^4 + c \cdot t^3 + d \cdot t^2 + e \cdot t + f$$

where

$$a = \frac{a_{start}}{2t_1^3} - 3\frac{v_{actual}}{t_1^4} - 6\frac{x_{actual} - x_{end}}{t_1^5}$$

$$b = \frac{3\,a_{start}}{2\,t_1^2} + 8\frac{v_{actual}}{t_1^3} + 15\frac{x_{actual} - x_{end}}{t_1^4}$$

$$c = \frac{3\,a_{start}}{2\,t_1} - 6\frac{v_{actual}}{t_1^2} - 10\frac{x_{actual} - x_{end}}{t_1^3}$$

$$d = \frac{a_{start}}{2}$$

$$e = v_{actual}$$

$$f = x_{actual}$$

where $a_{start}$ is the starting acceleration, $v_{actual}$ is the current acceleration of the motion system, $s_{actual}$ is the current distance of the motion system in the direction under consideration, $s_{end}$ is the maximum possible distance of the motion system, proceeding from $s_{actual}$, and t is the time until the end inclination angle is attained.

8. A device for controlling a motion system of a simulator provided for simulating motion values and/or acceleration values, wherein the three rotational and the tree translational motions in the three spatial axes are mapped by the motion system, comprising at least one input interface for predefining at least one acceleration value to be simulated, and comprising at least one output interface for activating the motion system, said at least one output interface being connectable to the motion system, wherein the device has a computing unit connected to the at least one input interface and output interface, said computing unit being designed for carrying out the above method according to one of claim 1 - 7 for controlling the motion system.

9. A simulator comprising a motion system for simulating motion values and/or acceleration values and a device as claimed in claim 8 connected to the motion system and provided for controlling the motion system.

**Revendications**

1. Procédé de commande d'un système de mouvement d'un simulateur prévu pour simuler des valeurs de mouvement et/ou d'accélération, dans lequel les trois mouvements de rotation et les trois mouvements de translation sont représentés sur trois axes spatiaux passant par le système de mouvement et dans lequel au moins une valeur d'accélération à simuler (1) est simulée par une inclinaison du système de mouvement par rapport à la verticale, consistant à

   - déterminer une courbe d'évolution de l'angle d'inclinaison du système de mouvement d'un angle d'inclinaison de départ du système de mouvement à un angle d'inclinaison final correspondant à la valeur d'accélération à simuler (1) en tenant compte d'au moins une vitesse d'inclinaison,

   **caractérisé par** le fait de

   - déterminer une courbe d'évolution de mouvement de translation (5) du système de mouvement en fonction de la valeur d'accélération à simuler (1) et d'une courbe d'évolution de valeurs d'accélération (2) de valeurs d'accélération simulées pendant l'inclinaison du système de mouvement afin de réduire une erreur de simulation (3) entre la valeur d'accélération à simuler (1) et les valeurs d'accélération respectives simulées de la courbe d'évolution de valeurs d'accélération (2), et
   - commander le système de mouvement pour simuler la valeur d'accélération à simuler en fonction de la courbe d'évolution déterminée des angles d'inclinaison et de la courbe d'évolution de mouvement de translation (5) déterminé.

2. Procédé selon la revendication 1, **caractérisé en ce que** la courbe d'évolution de valeurs d'accélération (2) est déterminée par la fonction

$$a(t) = g*sin(\Theta(t))$$

où a(t) est la courbe d'évolution de l'accélération, g est l'accélération de la pesanteur, et $\Theta(t)$ est la courbe d'évolution de l'angle d'inclinaison.

3. Procédé selon la revendication 1 ou 2, **caractérisé par** le fait de déterminer en outre la courbe d'évolution de mouvement de translation (5) du système de mouvement en fonction d'un espace de mouvement (6) disponible du système de mouvement, à partir d'une position de départ ($s_{ist}$) du système de mouvement.

4. Procédé selon l'une quelconque des revendications précédentes, **caractérisé par** le fait de déterminer en outre la courbe d'évolution de mouvement de translation (5) du système de mouvement en fonction d'un mouvement de départ ($v_{ist}$) du système de mouvement.

5. Procédé selon l'une quelconque des revendications précédentes, **caractérisé par** le fait de déterminer la courbe d'évolution de mouvement de translation (5) en tenant compte de la condition aux limites selon laquelle, à l'instant où l'angle d'inclinaison final est atteint, aucun mouvement de translation du système de mouvement n'est plus effectué.

6. Procédé selon l'une quelconque des revendications précédentes, **caractérisé par** le fait de déterminer la courbe d'évolution de l'angle d'inclinaison en fonction d'une vitesse d'inclinaison constante ou dépendant du temps, par exemple de 3° par seconde.

7. Procédé selon l'une quelconque des revendications précédentes, **caractérisé par** le fait de déterminer la courbe d'évolution de mouvement de translation (5) en fonction de la fonction de déplacement suivante (4) :

$$s(t) = a \cdot t^5 + b \cdot t^4 + c \cdot t^3 + d \cdot t^2 + e \cdot t + f$$

avec

$$a = -\frac{a_{anf}}{2t_1^3} - 3\frac{v_{ist}}{t_1^4} - 6\frac{x_{ist} - x_{end}}{t_1^5}$$

$$b = \frac{3}{2}\frac{a_{anf}}{2t_1^2} + 8\frac{v_{ist}}{t_1^3} + 15\frac{x_{ist} - x_{end}}{t_1^4}$$

$$c = -\frac{3}{2}\frac{a_{anf}}{t_1} - 6\frac{v_{ist}}{t_1^3} - 10\frac{x_{ist} - x_{end}}{t_1^3}$$

$$d = \frac{a_{anf}}{2}$$

$$e = v_{ist}$$

$$f = x_{ist}$$

où $a_{anf}$ est l'accélération initiale, $v_{ist}$ est l'accélération courante du système de mouvement, $s_{ist}$ est le déplacement courant du système de mouvement dans la direction observée, $s_{end}$ est le déplacement possible maximal du système de mouvement, à partir de $s_{ist}$, et t est le temps s'écoulant jusqu'à ce que l'angle d'inclinaison final soit atteint.

8. Dispositif destiné à commander un système de mouvement d'un simulateur prévu pour simuler des valeurs de mouvement et/ou d'accélération, dans lequel les trois mouvements de rotation et les trois mouvements de translation sont représentés sur les trois axes spatiaux passant par le système de mouvement, et comportant au moins une interface d'entrée destinée à prédéfinir au moins une valeur d'accélération à simuler et comportant au moins une interface de sortie pouvant être connectée au système de mouvement pour commander le système de mouvement, dans lequel le dispositif comporte une unité de calcul connectée à l'au moins une interface d'entrée et à l'au moins une interface de sortie, qui est conçue pour mettre en oeuvre le procédé ci-dessus selon l'une quelconque des revendications 1-7 afin de commander le système de mouvement.

9. Simulateur comportant un système de mouvement destiné à simuler des valeurs de mouvement et/ou d'accélération et un dispositif selon la revendication 8 connecté au système de mouvement et prévu pour commander le système

de mouvement.

Figur 1

Figur 2

# Figur 3

Figur 4